# EUROPEAN PATENT SPECIFICATION

(11) **EP 1 525 069 B1**
(45) Date of publication and mention of the grant of the patent: **15.04.2009**
(21) Application number: 03709364.8
(22) Date of filing: 26.02.2003
(51) Int. Cl.: B23K 26/38, B23K 26/06, B23K 26/08

(54) **SYSTEM AND METHOD OF LASER DRILLING USING A CONTINUOUSLY OPTIMIZED DEPTH OF FOCUS**
LASERBOHRSYSTEM UND -VERFAHREN UNTER VERWENDUNG EINER KONTINUIERLICH OPTIMIERTEN SCHÄRFENTIEFE
SYSTEME ET PROCEDE DE PERCAGE LASER AU MOYEN D'UNE PROFONDEUR DE FOYER OPTIMISEE

(30) Priority: 25.07.2002 US 398469 P; 08.10.2002 US 266999
(43) Date of publication of application: 27.04.2005
(73) Proprietor: Panasonic Corporation, Kadoma-shi Osaka 571-8501 (JP)
(72) Inventor: LIU, Xinbing, Acton, MA 01720 (US)
(74) Representative: Chapman, Paul Nicholas
(86) International application number: PCT/US2003/005909
(87) International publication number: WO 2004/011187

(56) References cited:
- WO-A-97/19217
- WO-A-03/004210
- JP-A- 3 066 488
- JP-A- 9 253 877
- US-A- 4 608 480
- US-A- 4 689 467
- US-A- 5 063 280
- US-A- 5 063 280
- US-B1- 6 195 164
- US-B1- 6 256 883
- PATENT ABSTRACTS OF JAPAN vol. 2002, no. 05, 3 May 2002 (2002-05-03) -& JP 2002 001563 A (TOSHIBA TEC CORP), 8 January 2002 (2002-01-08)
- PATENT ABSTRACTS OF JAPAN vol. 017, no. 645 (M-1517), 30 November 1993 (1993-11-30) -& JP 05 208288 A (HITACHI LTD), 20 August 1993 (1993-08-20)
- PATENT ABSTRACTS OF JAPAN vol. 012, no. 424 (M-761), 10 November 1988 (1988-11-10) -& JP 63 157778 A (TAISEI CORP), 30 June 1988 (1988-06-30)

## Description

The present invention generally relates to a laser drilling system and a method of adjusting depth of forms in a laser drilling system according to the preamble of claim 1 and 12 (see, for example, JP 5/208 288A), and particularly relates to focus depth control in a laser milling system.

### BACKGROUND OF THE INVENTION

Material ablation by pulsed light sources has been studied since the invention of the laser. Reports in 1982 of polymers having been etched by ultraviolet (UV) excimer laser radiation stimulated widespread investigations of the process for micromachining. Since then, scientific and industrial research in this field has proliferated - mostly spurred by the remarkably small features that can be drilled, milled, and replicated through the use of lasers.

Ultrafast lasers generate intense laser pulses with durations from roughly 10⁻¹¹ seconds (10 picoseconds) to 10⁻¹⁴ seconds (10 femtoseconds). Short pulse lasers generate intense laser pulses with durations from roughly 10⁻¹⁰ seconds (100 picoseconds) to 10⁻¹¹ seconds (10 picoseconds). A wide variety of potential applications for ultrafast and short pulse lasers in medicine, chemistry, and communications are being developed and implemented. These lasers are also a useful tool for milling or drilling holes in a wide range of materials. Hole sizes as small as a few microns, even sub-microns, can readily be drilled. High aspect ratio holes can be drilled in hard materials, such as cooling channels in turbine blades, nozzles in ink-jet printers, or via holes in printed circuit boards.

Patent Abstracts of Japan 05/208288 A (Hitachi Ltd) discloses apparatus and a method for machining a hole in a workpiece. The apparatus comprises a laser and a condensing lens which focuses a laser beam onto a workpiece. The workpiece is supported on a Z axis stage. Considering the depth of the hole determined by the energy density of the laser beam, the diameter of the hole and the focal distance of the condensing lens, the face of the workpiece being machined is elevated using the Z axis stage at every specified numbers of shots.

Patent Abstracts of Japan 2002001563 A (Toshiba Tec Corp) relates to laser apparatus, having a Z stage, and a method for processing an orifice plate using the apparatus. The aim of the method is to increase processing precision and minimize an unevenness of processing precision between adjacent processing units, irrespective of the flatness of the processing surface. Firstly, distances to each processing unit on the orifice plate are measured, and following adjustment calculations, the Z stage is controlled using adjusted data of each distance, while a laser beam is focussed in each processing unit.

United States Patent no. 4,689,467 (Inoue) discloses laser machining apparatus. The apparatus includes a lens system which focuses a laser beam onto a working point of a workpiece. During the boring of the workpiece, the lens system is moved and controlled such that rays reflected from the working point received at a sensor are maximized, and the focal point of the laser beam always coincides with the working point of the workpiece.

Ultrafast and short pulse laser systems can be designed to accommodate drilling and milling of thin materials (50 to 100 microns); however, there is a need in the field of laser micromachining to drill or mill a wider range of material thicknesses. Ablating thicker materials presents certain technological challenges, including maintaining control of the laser through the entire thickness of the material and providing a finished product that meets both customer specifications and established quality standards.

Several problems continue to exist in the field of material ablation with pulsed light sources, and one such problem relates to controlling the quality specifications of a laser-drilled final product. Recent advancements in the field of laser drilling have been effective in enhancing the quality (i.e., shape, contour, and repeatability) of finished products according to customer demands. However, a growing number of customers require an increased geometric complexity in their product designs. Using conventional industry techniques, it is difficult to meet the increasing quality market needs. What is needed is a way to control the quality specifications of a laser-drilled final product.

Another problem that persists in the field of material ablation with pulsed light sources relates to controlling laser drilling on a thick workpiece. In typical laser-drilling applications that work with thin materials, ablation need only be controlled through the range of a thin workpiece (such as 50 to 100 microns). However, as material thickness increases, ablation must be controlled through a wider range of thickness and through an increased number of ablation layers. As drilling is performed on thicker surfaces, maintaining laser parameters becomes increasingly more difficult. Therefore, greater control over the laser parameters that control ablation rates and hole shape geometry throughout the process becomes necessary. What is needed is a way to control laser drilling on a thick workpiece.

A further problem that continues to exist in the field of material ablation with pulsed light sources relates to maintaining a constant ablation rate on the surface of a thick workpiece throughout the drilling process. During ablation of a layer in laser drilling, a material void is created at the contact point on the workpiece surface, i.e., the point at which the laser spot size intersects with the material surface. Once a void in the material is created, the expected contact point is no longer the same in that location on the workpiece due to the removal of material. Because of the variations in laser beam intensity and spot size at the contact point, the ablation rate changes. What is needed is a way to maintain a constant ablation rate on the surface of a thick workpiece throughout the drilling process.

A still further problem that continues to exist in the field of material ablation with pulsed light sources relates to maintaining constant laser beam intensity and constant spot size on the surface of a thick workpiece throughout the drilling process. Laser beam spot size is measured at the point where the focused laser beam and the surface of the workpiece material intersect. At a known laser beam intensity and known spot size, the ablation rate can be calculated and thus predicted in order to meet customer specifications. In a thick workpiece, however, as layers of material are ablated away the workpiece surface is no longer in the focal plane of the laser drilling system. This means that the laser beam intensity and spot size are no longer the same as originally intended (at the point of ablation) and, thus, ablation control is decreased. A constant spot size is required to prevent hole geometry distortion and inconsistent geometrical shaping due to lack of ablation control. What is needed is a way to maintain constant laser beam intensity and constant spot size on the surface of a thick workpiece throughout the drilling process.

### SUMMARY OF THE INVENTION

According to a first aspect of the present invention, there is provided a laser drilling system as claimed in claim 1.

According to a second aspect of the invention there is provided a method of adjusting depth of focus in a laser drilling system as claimed in claim 12.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

### BRIEF DESCRIPTION OF THE DRAWINGS

The present invention will become more fully understood from the detailed description and the accompanying drawings, wherein:
Figure 1 is a perspective view of a spot size alignment within a laser drilling system;
Figure 2 is a simplified schematic of a laser drilling system;
Figures 3A-C are magnified views of depth of focus adjustments made using a moveable stage; and
Figure 4 is a flow chart diagram depicting a method of adjusting depth of focus in a laser drilling system according to the present invention.

### DETAILED DESCRIPTION OF THE PREFERRED EMBODIMENTS

The following description of the preferred embodiment(s) is merely exemplary in nature and is in no way intended to limit the invention, its application, or uses.

The present invention provides a system for and a method of continuously optimizing the depth of focus of a laser drilling system using a moveable workpiece stage to provide consistent, controlled ablation throughout the milling process.

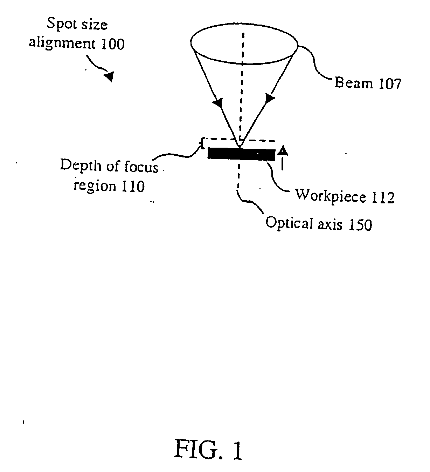

Referring to Figure 1, a perspective view of a spot size alignment 100 within a laser drilling system includes a workpiece 112, a beam 107, a depth of focus region 110, and an optical axis 150. Depth of focus region 110 is a region along optical axis 150 of beam 107 in which the spot size of beam 107 maintains a relatively constant radius that can be quantitatively determined.

Adjustments to the optical path of beam 107 or workpiece 112 along optical axis 150 of beam 107 may adjust depth of focus region 110 to an optimal point. The spot size of beam 107 is calculated to center the spot size of beam 107 within depth of focus region 110, thereby aligning beam 107 to the designated surface contact point on workpiece 112.

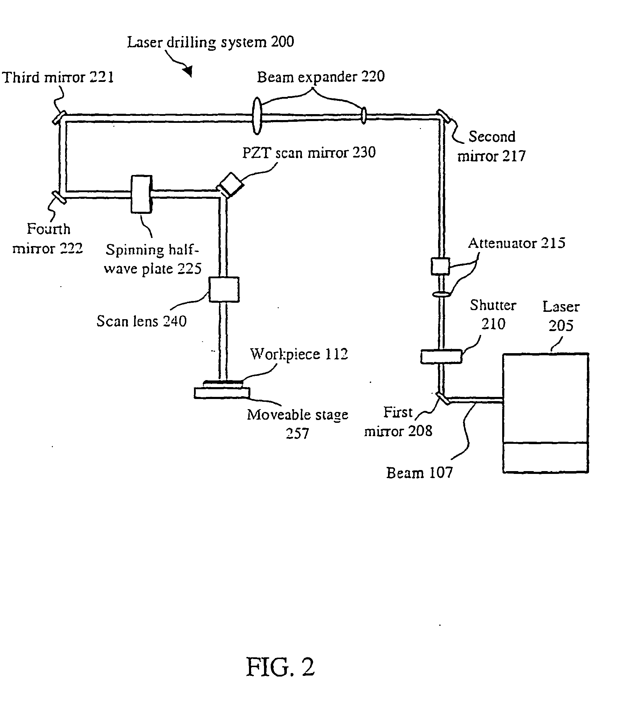

Figure 2 shows a simplified schematic of a laser drilling system 200, including a laser 205, a shutter 210, an attenuator 215, a beam expander 220, a spinning half-wave plate 225, a first mirror 208, a second mirror 217, a third mirror 221, a fourth mirror 222, a piezo electric transducer (PZT) scan mirror 230, a scan lens 240, and a moveable stage 257, arranged as shown. Although the present invention uses a picosecond laser system, the present invention may be generalized for use with other laser systems, such as excimer, CO₂, and copper vapor laser systems.

Although all elements of laser drilling system 200 are conventional, a brief description of the operation of laser drilling system 200 is provided below. In alternate embodiments, changes in the elements of laser drilling system 200 may be required. The present invention is not limited to the current selection and arrangement of elements in laser drilling system 200.

In operation, picosecond laser 205 emits beam 107 along the optical path identified in Figure 2 above. Beam 107 propagates along the optical path, where it is incident upon first mirror 208. First mirror 208 redirects beam 107 along the optical path, where it is incident upon shutter 210. Shutter 210 opens and closes to selectively illuminate the workpiece material. Beam 107 exits shutter 210 and propagates along the optical path to attenuator 215. Attenuator 215 filters the energy of picosecond laser 205 in order to precisely control ablation parameters. Beam 107 exits attenuator 215 and propagates along the optical path, where it is incident upon second mirror 217. Second mirror 217 redirects beam 107 along the optical path, where it is incident upon beam expander 220.

Beam expander 220 increases the size of beam 107 to match the pupil size of scan lens 240. Beam 107 exits beam expander 220 and propagates along the optical path, where it is incident upon third mirror 221. Third mirror 221 redirects beam 107 along the optical path, where it is incident upon fourth mirror 222. Fourth mirror 222 redirects beam 107 along the optical path, where it is incident upon spinning half-wave plate 225. Spinning half-wave plate 225 changes the polarization of beam 107. Upon exiting spinning half-wave plate 225, beam 107 propagates along the optical path, where it is incident upon PZT scan mirror 230. PZT scan mirror 230 moves in a pre-defined pattern using a drilling algorithm (not shown) to drill the holes in workpiece 112. PZT scan mirror 230 redirects beam 107 along the optical path, where it is incident upon scan lens 240. Scan lens 240 determines the spot size of beam 107 upon workpiece 112. Beam 107 exits scan lens 240 and propagates along the optical path, where it is incident upon workpiece 112. Beam 107 ablates workpiece 112 in a pattern according to the pre-defined drilling algorithm. Moveable stage 257 is adjusted on a vertical axis to maintain accurate depth of focus and spot size of beam 107 on the contact surface of workpiece 112 during ablation. It is readily understood that to maintain accurate depth of focus, the scan lens 240 may also be adjustable along the vertical axis, such that the workpiece 112 remains in a fixed position.

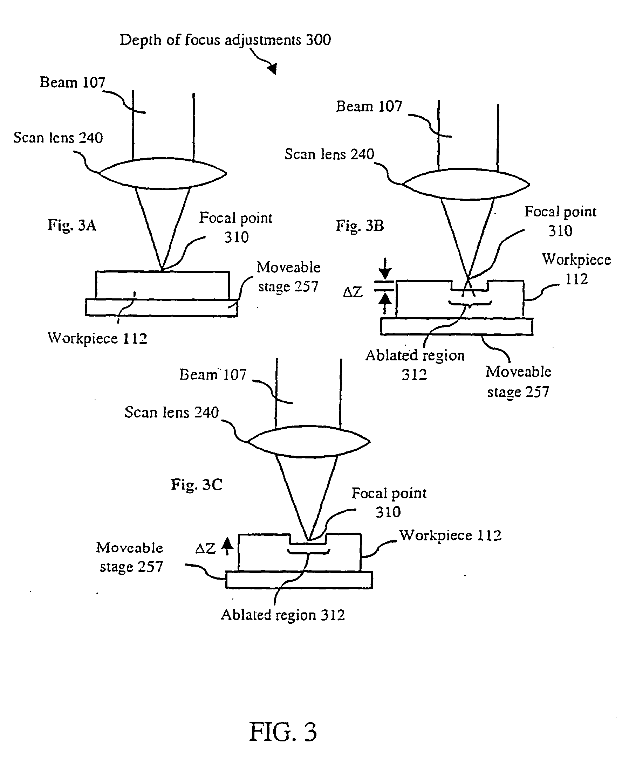

Figures 3A-C show magnified views of depth of focus adjustments 300 made using moveable stage 257, and include a focal point 310 and an ablated region 312. Additional elements of laser drilling system 200 are shown in Figures 3A-C for the purpose of clarity.

As shown in Figure 3A, scan lens 240 directs beam 107 to focal point 310 on the surface of workpiece 112 for material ablation. Figure 3B illustrates how ablated region 312 is formed by beam 107, thereby causing focal point 310 to become displaced a distance equal to the depth of the ablated layer. The feed distance and direction of moveable stage 257 is identified in the present invention as ΔZ.

Figure 3C illustrates the adjustment made (shown as ΔZ) to refocus beam 107 on the contact surface of workpiece 112. The distance that moveable stage 257 moves (ΔZ) is predetermined based on the calculated ablation rate.

In operation, initial depth of focus settings are determined for focal point 310 of beam 107 on the contact surface of workpiece 112. As ablation region 312 is formed, a control unit (not shown) mechanically adjusts the feed distance ΔZ of moveable stage 257 to realign focal point 310 of beam 107 to the depth of the next layer to be ablated. This technique provides a continuous ablation of material within workpiece 112 while providing constant laser intensity to focal point 310 within selected depth of focus region 110.

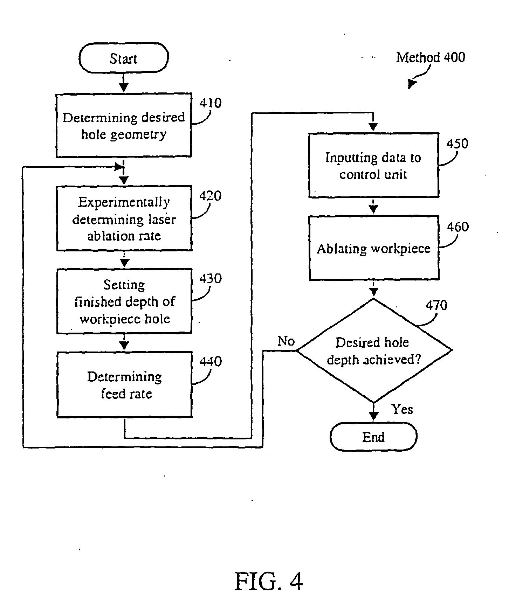

Figure 4 shows a method 400 of adjusting the depth of focus in laser drilling system 200 according to the invention, the steps of which are now described with reference to Figures 1-3.

At step 410, a desired hole geometry is determined. In this step, an operator or technician uses customer-specified information, such as CAD files, and technical notes to determine the desired hole geometry, including taper angle, exit hole diameter, and entrance hole diameter. In the present invention, the desired shape and dimensions are circular holes. However, this invention is not limited by a designated shape and may also be applied to the drilling of a general pattern geometry, such as lines, curves, squares, etc.

At step 420 a laser ablation rate is experimentally determined. In this step, an operator or technician determines the ablation rate (or material removal rate) with a given set of laser drilling parameters. Governing parameters of ablation rate include repetition rate, spot size, and laser power. Prior to milling workpiece 112, a number of trial milling runs are performed to measure and make adjustments to laser drilling system 200 to affect the ablation rate.

At step 430, a finished depth of the workpiece hole is set. In this step, an operator or technician determines the final desired hole depth of workpiece 112 using the material thickness of workpiece 112 and the desired hole shape as derived from step 410.

At step 440, a feed rate is determined. In this step, an operator, technician, or automated tool uses calculations derived from steps 410, 420, and 430 to determine the feed rate of moveable stage 257. The feed rate is equal to the determined ablation rate expressed in ablated depth per unit time for any particular drilling application. For example, if the ablation rate is determined to be 1 µm/sec for a particular material and size and shape for a given set of laser parameters, the feed rate will be 1 µm/sec.

At step 450, data is input to a control unit. In this step, an operator, technician, or automated tool inputs the data derived from steps 420, 430, and 440 into a control unit to enable adjustment of moveable stage 257.

At step 460, a workpiece is ablated. In this step, laser drilling system 200 adjusts depth of focus parameters to the surface of workpiece 112. Laser drilling system 200 then performs a milling algorithm to ablate material within workpiece 112. Ablation of workpiece 112 within entire ablated region 312 at pre-determined ablation depths, are based on the ablation rate as determined in step 420.

At step 470, a determination is made regarding whether a desired hole depth has been achieved. In this decision step, the milling algorithm determines whether the desired milled shape has been achieved. The milled shape is considered to be achieved when the milling algorithm has completed the pre-set number of ablation layers and moveable stage 257 has achieved a predetermined setpoint for the desired hole depth as determined in step 430. If yes, method 400 ends: if no, method 400 returns to step 420.

The present invention has several advantages. A first advantage of the present invention is that it provides a way to control the quality specifications of a laser-drilled final product. A second advantage of the present invention is that it provides a way to control laser drilling on a thick workpiece. A third advantage of the present invention is that it provides a way to maintain a constant ablation rate on the surface of a thick workpiece throughout the drilling process. A fourth advantage of the present invention is that it provides a way to maintain constant laser beam intensity and constant spot size on the surface of a thick workpiece throughout the drilling process. A fifth advantage of the present invention is that it provides a way to make adjustments to the depth of focus using only one moveable element. A sixth advantage of the present invention is that it allows simplified patterns to be made without taking into account material thickness.

The present invention also has some disadvantages. One disadvantage of the present invention is that if the feed rate of the moveable stage is too slow, then it may be difficult for the invention to maintain a consistent geometric hole shape. However, further advances in tooling hardware, software, and microcontrolling devices in the field of micromachining may soon alleviate this area of concern.

There also exists another way to solve the same problem(s) addressed by the invention. One other way to solve the same problem is to adjust the depth of focus of the laser drilling system by manually adjusting individual laser system elements (such as the scan lens). However, this technique is time consuming and cumbersome, and could introduce optical alignment problems in the laser drilling system.

The description of the invention is merely exemplary in nature and, thus, variations that do not depart from the gist of the invention are intended to be within the scope of the invention as defined in the appended claims.

## Claims

1. A laser drilling system (200), comprising:
a laser (205) emitting a laser beam (107) having a focal plane;
a moveable stage (257) operable to support a workpiece (112); and **characterised by** a control module arranged for achieving the following steps:
(i) determining desired hole geometry;
(ii) experimentally determining laser ablation rate with a given set of laser drilling parameters;
(iii) setting finished depth of the workpiece's hole;
(iv) determining feed rate by using calculations from previous steps;
(v) inputting data in a control unit; and
(vi) ablating the workpiece until a desired hole depth is achieved, wherein the laser drilling system adjusts the depth of focus parameters to the surface of the workpiece, and wherein the position of the workpiece is adjusted in relation with the feed rate, thereby maintaining a constant ablation rate on the exposed surface of the workpiece throughout the drilling process.

2. The system of claim 1 comprising a moveable stage (257) operable to support the workpiece (112), wherein said control module is operable to adjust a position of said moveable stage.

3. The system of claim 2, wherein said control module is operable to adjust the position of said moveable stage (257) as a function of ablation rate of material of said workpiece (112) respective of said laser beam (107).

4. The system of claim 2, wherein said control module is operable to adjust the position of said moveable stage (257) as a function of a shape formed in said workpiece (112) as a result of the drilling process.

5. The system of claim 2, wherein said control module is operable to adjust the position of said moveable stage (257) as a function of a tool path employed to form a shape in said workpiece (112) during the drilling process.

6. The system of claim 2, wherein said control module is operable to adjust the position of said moveable stage (257) as a function of an algorithm employing a tool path to form a shape in said workpiece (112) during the drilling process.

7. The system of claim 2, wherein said control module is operable to adjust the position of said moveable stage (257) as a function of:
an ablation rate of material of said workpiece respective of said laser beam;
a shape formed in said workpiece (112) as a result of the drilling process;
a tool path employed to form said shape in said workpiece during the drilling process; and
an algorithm employing said tool path to form said shape in said workpiece during the drilling process.

8. The system of claim 7, wherein the tool path is based on an analyzed, desired hole geometry.

9. The system of claim 1 wherein said control module is operable to adjust the position of said workpiece (112) as a function of:
a shape formed in said workpiece as a result of the drilling process.

10. The system of claim 9, wherein said control module is operable to adjust the position of said workpiece (112) as a function of:
a tool path forming said shape in said workpiece during the drilling process; and
an algorithm employing said tool path to form said shape in said workpiece during the drilling process.

11. The system of claim 1 comprising a moveable scan lens (240) adapted to focus the laser beam (107) on the surface of the workpiece (112), wherein said control module is operable to adjust a position of the scan lens.

12. A method of adjusting depth of focus in a laser drilling system (200), comprising:
generating a laser beam (107) having a focal plane;
positioning a workpiece (112) in the focal plane, wherein a surface of the workpiece is exposed to the laser beam at a point intersecting the focal plane; and
adjusting a position of the workpiece in relation to the focal plane of the laser,
wherein said method is **characterised by** comprising the steps of:
(i) determining desired hole geometry (410);
(ii) experimentally determining laser ablation rate (420) with a given set of laser drilling parameters;
(iii) setting finished depth of the workpiece's hole (430);
(iv) determining feed rate (440) by using calculations from previous steps;
(v) inputting data in a control unit (450); and
(vi) ablating the workpiece (460) until a desired hole depth is achieved, wherein the laser drilling system adjusts the depth of focus parameters to the surface of the workpiece, and wherein the position of the workpiece is adjusted in relation with the feed rate, thereby maintaining a constant ablation rate on the exposed surface of the workpiece throughout the drilling process.

13. The method of claim 12 comprising adjusting a position of a moveable stage (257) supporting the workpiece (112).

14. The method of claim 13 comprising adjusting the position of the moveable stage (257) as a function of ablation rate of material of the workpiece respective of the laser beam (107).

15. The method of claim 13 comprising adjusting the position of the moveable stage (257) as a function of a shape formed in the workpiece (112) as a result of the drilling process.

16. The method of claim 13 comprising adjusting the position of the moveable stage (257) as a function of a tool path employed to form a shape in said workpiece (112) during the drilling process.

17. The method of claim 13 comprising adjusting the position of the moveable stage(257) as a function of an algorithm employing a tool path to form a shape in said workpiece (112) during the drilling process.

18. The method of claim 13 wherein said control module is operable to adjust the position of said moveable stage (257) as a function of:
an ablation rate of material of said workpiece (112) respective of said laser beam (107);
a shape formed in said workpiece (112) as a result of the drilling process;
a tool path employed to form said shape in said workpiece during the drilling process; and
an algorithm employing said tool path to form said shape in said workpiece during the drilling process.

19. The method of claim 18 wherein the tool path is based on an analyzed, desired hole geometry.

20. The method of claim 12 comprising adjusting the position of said workpiece (112) as a function of:
a shape formed in said workpiece as a result of the drilling process.

21. The method of claim 20 comprising adjusting the position of said workpiece (112) as a function of:
a tool path forming said shape in said workpiece during the drilling process; and
an algorithm employing said tool path to form said shape in said workpiece during the drilling process.

22. The method of claim 12 further comprises passing the laser beam (107) through a scan lens (240) to form the focal plane and adjusting the position of the focal plane by moving the scan lens.

23. The system of Claim 1 in combination with the workpiece (112), wherein the workpiece (112) is further defined as a nozzle plate of an inkjet head.

24. The method of Claim 12 wherein the workpiece (112) is further defined as a nozzle plate of an ink-jet head.

## Patentansprüche

1. Laserbohrsystem (200) umfassend
einen Laser (205), der einen Laserstrahl (107) emittiert, der eine Brennebene besitzt,
ein bewegbares Gestell (257), das zum Tragen eines Werkstücks (112) dient, und
**gekennzeichnet durch**
eine Kontrolleinrichtung, die dazu ausgebildet ist, die folgenden Schritte durchzuführen:
(i) bestimmen der gewünschten Lochgeometrie,
(ii) experimentelles bestimmen einer Laserablationsrate mit einem gegebenen Satz von Laserbohrparametern,
(iii) setzen einer fertig gestellten Tiefe des Lochs des Werkstücks,
(iv) bestimmen einer Vorschubrate unter Verwendung von Berechnungen aus vorhergehenden Schritten,
(v) eingeben von Daten in eine Steuereinheit und
(vi) abtragen des Werkstücks, bis eine gewünschte Lochtiefe erreicht ist, wobei das Laserbohrsystem die Tiefenschärfe-Parameter auf die Oberfläche des Werkstücks einstellt und wobei die Position des Werkstücks in Relation zu der Vorschubrate eingestellt wird, wodurch während des ganzen Bohrprozesses eine konstante Ablationsrate auf der bestrahlten Fläche des Werkstücks erzielt wird.

2. System nach Anspruch 1, umfassend ein bewegbares Gestell (257), das zum Tragen eines Werkstücks (112) dient, wobei die Kontrolleinrichtung dazu dient, eine Position des bewegbaren Gestells einzustellen.

3. System nach Anspruch 2, wobei die Kontrolleinrichtung dazu dient, die Position des bewegbaren Gestells (257) in Abhängigkeit von der Ablationsrate von Material des Werkstücks (112) entsprechend dem Laserstrahl (107) einzustellen.

4. System nach Anspruch 2, wobei die Kontrolleinrichtung dazu dient, die Position des bewegbaren Gestells (257) in Abhängigkeit von einer in dem Werkstück (112) als Ergebnis des Bohrprozesses gebildeten Form einzustellen.

5. System nach Anspruch 2, wobei die Kontrolleinrichtung dazu dient, die Position des bewegbaren Gestells (257) in Abhängigkeit von einem angewendeten Werkzeugweg einzustellen, um während des Bohrprozesses eine Form in dem Werkstück (112) zu bilden.

6. System nach Anspruch 2, wobei die Kontrolleinrichtung dazu dient, die Position des bewegbaren Gestells (257) in Abhängigkeit von einem Algorithmus zum Anwenden eines Werkzeugwegs einzustellen, um während des Bohrprozesses eine Form in dem Werkstück (112) zu bilden.

7. System nach Anspruch 2, wobei die Kontrolleinrichtung dazu dient, die Position des bewegbaren Gestells (257) in Abhängigkeit von folgendem einzustellen:
einer Ablationsrate von Material des Werkstücks entsprechend dem Laserstrahl,
einer in dem Werkstück (112) als Ergebnis des Bohrprozesses gebildeten Form,
einem angewendeten Werkzeugweg, um während des Bohrprozesses die Form in dem Werkstück zu bilden, und
einem Algorithmus zum Anwenden des Werkzeugwegs, um während des Bohrprozesses die Form in dem Werkstück zu bilden.

8. System nach Anspruch 7, wobei der Werkzeugweg auf einer analysierten, gewünschten Lochgeometrie basiert.

9. System nach Anspruch 1, wobei die Kontrolleinrichtung dazu dient, die Position des Werkstücks (112) in Abhängigkeit von folgendem einzustellen:
einer in dem Werkstück als Ergebnis des Bohrprozesses gebildeten Form.

10. System nach Anspruch 9, wobei die Kontrolleinrichtung dazu dient, die Position des Werkstücks (112) in Abhängigkeit von folgendem einzustellen:
einem Werkzeugweg, der während des Bohrprozesses die Form in dem Werkstück bildet, und
einem Algorithmus zum Anwenden des Werkzeugwegs, um während des Bohrprozesses die Form in dem Werkstück zu bilden.

11. System nach Anspruch 1, umfassend eine bewegbare Scanlinse (240), die zum Fokussieren des Laserstrahls (107) auf die Oberfläche des Werkstücks (112) ausgebildet ist, wobei die Kontrolleinrichtung zum Einstellen einer Position der Scanlinse dient.

12. Verfahren zum Einstellen der Tiefenschärfe in einem Laserbohrsystem (200), umfassend
erzeugen eines Laserstrahls (107), der eine Brennebene besitzt,
positionieren eines Werkstücks (112) in der Brennebene, wobei eine Oberfläche des Werkstücks mit dem Laserstrahl an einem Punkt bestrahlt wird, in dem die Brennebene geschnitten wird,
einstellen einer Position des Werkstücks in Relation zu der Brennebene des Lasers,
wobei das Verfahren **dadurch gekennzeichnet ist, dass** es folgende Schritte umfasst:
(i) bestimmen einer gewünschten Lochgeometrie (410),
(ii) experimentelles bestimmen einer Laserablationsrate (420) mit einem gegebenen Satz von Laserbohrparametern,
(iii) setzen einer fertig gestellten Tiefe des Lochs des Werkstücks (430),
(iv) bestimmen einer Vorschubrate (440) unter Verwendung von Berechnungen aus vorhergehenden Schritten,
(v) eingeben von Daten in eine Steuereinheit (450) und
(vi) abtragen des Werkstücks (460), bis eine gewünschte Lochtiefe erreicht ist, wobei das Laserbohrsystem die Tiefenschärfe-Parameter auf die Oberfläche des Werkstücks einstellt und wobei die Position des Werkstücks in Relation zu der Vorschubrate eingestellt wird, wodurch während des ganzen Bohrprozesses eine konstante Ablationsrate auf der bestrahlten Fläche des Werkstücks erzielt wird,

13. Verfahren nach Anspruch 12, umfassend das Einstellen einer Position eines bewegbaren Gestells (257), welches das Werkstück (112) trägt.

14. Verfahren nach Anspruch 13, umfassend das Einstellen der Position des bewegbaren Gestells (257) in Abhängigkeit von der Ablationsrate von Material des Werkstücks entsprechend dem Laserstrahl (107),

15. Verfahren nach Anspruch 13, umfassend das Einstellen der Position des bewegbaren Gestells (257) in Abhängigkeit von einer in dem Werkstück (112) als Ergebnis des Bohrprozesses gebildeten Form.

16. Verfahren nach Anspruch 13, umfassend das Einstellen der Position des bewegbaren Gestells (257) in Abhängigkeit von einem angewendeten Werkzeugweg, um während des Bohrprozesses eine Form in dem Werkstück (112) zu bilden.

17. Verfahren nach Anspruch 13, umfassend das Einstellen der Position des bewegbaren Gestells (257) in Abhängigkeit von einem Algorithmus zum Anwenden eines Werkzeugwegs, um während des Bohrprozesses eine Form in dem Werkstück (112) zu bilden.

18. Verfahren nach Anspruch 13, wobei die Kontrolleinrichtung dazu dient, die Position des bewegbaren Gestells (257) in Abhängigkeit von folgendem einzustellen:
einer Ablationsrate von Material des Werkstücks (112) entsprechend dem Laserstrahl (107),
einer in dem Werkstück (112) als Ergebnis des Bohrprozesses gebildeten Form,
einem angewendeten Werkzeugweg, um während des Bohrprozesses die Form in dem Werkstück zu bilden, und
einem Algorithmus zum Anwenden des Werkzeugwegs, um während des Bohrprozesses die Form in dem Werkstück zu bilden,

19. Verfahren nach Anspruch 18, wobei der Werkzeugweg auf einer analysierten, gewünschten Lochgeometrie basiert.

20. Verfahren nach Anspruch 12, umfassend das Einstellen der Position des Werkstücks (112) in Abhängigkeit von folgendem:
einer in dem Werkstück als Ergebnis des Bohrprozesses gebildeten Form.

21. Verfahren nach Anspruch 20, umfassend das Einstellen der Position des Werkstücks (112) in Abhängigkeit von folgendem:
einem Werkzeugweg, der während des Bohrprozesses die Form in dem Werkstück bildet, und
einem Algorithmus zum Anwenden des Werkzeugwegs, um während des Bohrprozesses die Form in dem Werkstück zu bilden.

22. Verfahren nach Anspruch 12, ferner umfassend das Passieren des Laserstrahls (107) durch eine bewegbare Scanlinse (240), um die die Brennebene zu bilden, und Einstellen der Position der Brennebene durch Bewegen der Scanlinse.

23. System nach Anspruch 1 in Kombination mit dem Werkstück (112), wobei das Werkstück (112) außerdem als Düsenplatte eines Tintenstrahl-Druckkopfes definiert ist.

24. Verfahren nach Anspruch 12, wobei das Werkstück (112) außerdem als Düsenplatte eines Tintenstrahl-Druckkopfes definiert ist.

## Revendications

1. Système (200) de perçage laser comprenant :
un laser (205) émettant un faisceau (107) laser ayant un plan focal ;
un plateau (257) mobile pouvant fonctionner pour supporter une pièce (112) ; et **caractérisé par**
un module de commande, conçu pour obtenir les stades suivants ;
(i) détermination d'une géométrie souhaitée du trou ;
(ii) détermination expérimentalement de la vitesse d'ablation laser avec un jeu donné de paramètres de perçage laser ;
(iii) fixation d'une profondeur finie du trou de la pièce :
(iv) détermination de la vitesse d'alimentation en utilisant des calculs des stades précédents :
(v) entrée de données dans une unité de commande ; et
(vi) ablation de la pièce jusqu'à ce qu'une profondeur souhaitée du trou soit atteinte, dans lequel le système de perçage laser ajuste la profondeur de paramètres de foyer à la surface de la pièce et dans lequel la position de la pièce est ajustée en liaison avec la vitesse d'alimentation en maintenant ainsi une vitesse d'ablation constante sur la surface exposée de la pièce pendant toute l'opération de perçage.

2. Système suivant la revendication 1 comprenant un plateau (257) mobile pouvant fonctionner pour supporter la pièce (112), le module de commande pouvant fonctionner pour ajuster une position du plateau mobile.

3. Système suivant la revendication 2, dans lequel le module de commande peut fonctionner pour ajuster la position du plateau (257) mobile en fonction de la vitesse d'ablation du matériau de la pièce (112) par rapport au faisceau (107) laser.

4. Système suivant la revendication 2, dans lequel le module de commande peut fonctionner pour ajuster la position du plateau (257) mobile en fonction d'une forme formée dans la pièce (112) en résultat de l'opération de perçage.

5. Système suivant la revendication 2, dans lequel le module de commande peut fonctionner pour ajuster la position du plateau (257) mobile en fonction du trajet d'un outil employé pour former une forme dans la pièce (112) pendant l'opération de perçage.

6. Système suivant la revendication 2, dans lequel le module de commande peut fonctionner pour ajuster la position du plateau (257) mobile en fonction d'un algorithme employant un trajet de l'outil pour former une forme dans la pièce (112) pendant l'opération de perçage.

7. Système suivant la revendication 2, dans lequel le module de commande peut fonctionner pour ajuster la position du plateau (257) mobile en fonction de :
une vitesse d'ablation du matériau de la pièce par le faisceau laser ;
une forme formée dans la pièce (112) en résultat de l'opération de perçage ;
un trajet d'un outil employé pour former la forme dans la pièce pendant l'opération de perçage ;
un algorithme employant le trajet d'un outil pour former la forme dans la pièce pendant l'opération de perçage.

8. Système suivant la revendication 7, dans lequel le trajet d'un outil repose sur une géométrie analysée et souhaitée du trou.

9. Système suivant la revendication 1, dans lequel le module de commande peut fonctionner pour ajuster la position de la pièce (112) en fonction de :
une forme formée dans la pièce en résultat de l'opération de perçage.

10. Système suivant la revendication 9, dans lequel le module de commande peut fonctionner pour ajuster la position de la pièce (112) en fonction de :
un trajet d'un outil formant la forme dans la pièce pendant l'opération de perçage : et
un algorithme employant le trajet d'un outil pour former la forme dans la pièce pendant l'opération de perçage.

11. Système suivant la revendication 1 comprenant une lentille (240) mobile de balayage conçue pour focaliser le faisceau (107) laser sur la surface de la pièce (112), le module de commande pouvant fonctionner pour ajuster une position de la lentille de balayage.

12. Procédé d'ajustement de la profondeur de foyer dans un système (200) de perçage laser, dans lequel :
on produit un faisceau (107) laser ayant un plan focal ;
on met une pièce (112) en position dans le plan focal, une surface de la pièce étant exposée au faisceau laser en un point coupant le plan focal ; et
on ajuste une position de la pièce en relation au plan focal du laser,
dans lequel le procédé est **caractérisé en ce qu'**il comprend les stades dans lesquels :
(i) on détermine une géométrie (410) souhaitée du trou ;
(ii) on détermine expérimentalement une vitesse (420) d'ablation laser avec un jeu donné de paramètres de perçage laser ;
(iii) on fixe une profondeur finie du trou (430) de la pièce ;
(iv) on détermine une vitesse (440) d'alimentation en utilisant des calculs des stades précédents :
(v) on entre des données (450) dans une unité de commande ; et
(vi) on pratique une ablation dans la pièce (460) jusqu'à obtention d'une profondeur souhaitée du trou, dans lequel le système de perçage laser ajuste la profondeur de paramètres de foyer à la surface de la pièce et dans lequel la position de la pièce est ajustée en liaison avec la vitesse d'alimentation en maintenant ainsi une vitesse d'ablation constante sur la surface exposée de la pièce pendant toute l'opération de perçage.

13. Procédé suivant la revendication 12, dans lequel on ajuste une position d'un plateau (257) mobile qui supporte la pièce (112).

14. Procédé suivant la revendication 13, dans lequel on ajuste la position du plateau (257) mobile en fonction d'une vitesse d'ablation du matériau de la pièce par rapport au faisceau (107) laser.

15. Procédé suivant la revendication 13, dans lequel on ajuste la position du plateau (257) mobile en fonction d'une forme formée dans la pièce (112) en résultat de l'opération de perçage.

16. Procédé suivant la revendication 13, dans lequel on ajuste la position du plateau (257) mobile en fonction d'un trajet d'un outil employé pour former une forme dans la pièce (112) pendant l'opération de perçage.

17. Procédé suivant la revendication 13, dans lequel on ajuste la position du plateau (257) mobile en fonction d'un algorithme employant le trajet d'un outil pour former une forme dans la pièce (112) pendant l'opération de perçage.

18. Procédé suivant la revendication 13, dans lequel on ajuste la position du plateau (257) mobile en fonction de :
une vitesse d'ablation du matériau de la pièce (112) par le faisceau (107) laser ;
une forme formée dans la pièce (112) en résultat de l'opération de perçage ;
un trajet d'outil employé pour former la forme dans la pièce pendant l'opération de perçage :
un algorithme employant le trajet d'un outil pour former la forme dans la pièce pendant l'opération de perçage.

19. Procédé suivant la revendication 18, dans lequel le trajet d'un outil repose sur une géométrie analysée et souhaitée du trou.

20. Procédé suivant la revendication 12, dans lequel on ajuste la position de la pièce (112) en fonction de :
une forme formée dans la pièce en résultat de l'opération de perçage.

21. Procédé suivant la revendication 20, dans lequel on ajuste la position de la pièce (112) en fonction de :
un trajet d'un outil formant la forme dans la pièce pendant l'opération de perçage ; et
un algorithme employant le trajet d'un outil pour former la forme dans la pièce pendant l'opération de perçage.

22. Procédé suivant la revendication 12, dans lequel, en outre, on fait passer le faisceau (107) laser dans une lentille (240) de balayage pour former le plan focal et on ajuste la position du plan focal en déplaçant la lentille de balayage.

23. Système suivant la revendication 1, en combinaison avec la pièce (112), dans lequel la pièce (112) est définie, en outre, comme étant un plaque de buse d'une tête d'injection d'encre.

24. Procédé suivant la revendication 12, dans lequel la pièce (112) est définie, en outre, comme une plaque de buse d'une tête d'injection d'encre.
